(19) Europäisches Patentamt
European Patent Office
Office européen des brevets

(11) **EP 1 398 873 B1**

(12) **FASCICULE DE BREVET EUROPEEN**

(45) Date de publication et mention
de la délivrance du brevet:
**26.12.2007 Bulletin 2007/52**

(51) Int Cl.:
***H03D 7/14*** *(2006.01)*

(21) Numéro de dépôt: **03291657.9**

(22) Date de dépôt: **04.07.2003**

(54) **Mélangeur utilisant une cellule à Gilbert**

Gilbert-Zellen-Mischer

Gilbert-cell mixer

(84) Etats contractants désignés:
**DE FR GB IT**

(30) Priorité: **28.08.2002 FR 0210647**

(43) Date de publication de la demande:
**17.03.2004 Bulletin 2004/12**

(73) Titulaire: **STMicroelectronics S.A.**
**92120 Montrouge (FR)**

(72) Inventeurs:
• **Pellat, Bruno**
**38660 La Terrasse (FR)**

• **Gellida, Sylvie**
**38000 Grenoble (FR)**
• **Grasset, Jean-Charles**
**38430 Moirans (FR)**
• **Rivoirard, Frédéric**
**38600 Fontaine (FR)**

(74) Mandataire: **Zapalowicz, Francis**
**Bureau Casalonga & Josse**
**Bayerstrasse 71/73**
**80335 München (DE)**

(56) Documents cités:
US-A- 5 532 637     US-A- 5 613 233
US-A- 5 886 547     US-A- 6 023 196

**Description**

L'invention concerne la transposition de fréquence et s'applique avantageusement mais non limitativement dans le domaine de la radiofréquence, par exemple en téléphonie mobile, dans lequel les circuits radiofréquence utilisent largement les dispositifs de transposition de fréquence, ou mélangeurs de fréquence, tant à l'émission qu'à la réception.

A l'émission, les mélangeurs de fréquence, qui sont en l'espèce des circuits élévateurs de fréquence, ont pour but de transposer l'information en bande de base autour de la porteuse d'émission. En réception, les mélangeurs de fréquence sont des montages abaisseurs de fréquence.

Les récepteurs radiofréquence actuels sont basés sur une architecture à conversion directe. En d'autres termes, selon une telle architecture, le signal d'entrée est directement converti en bande de base sans nécessiter de transposition intermédiaire. Une telle architecture présente des avantages incontestables, notamment l'absence de filtres externes à fréquence intermédiaire.

Cependant, plusieurs inconvénients rendent la conception de tels récepteurs compliquée. L'un de ces inconvénients est dû au fait que la bande du signal de sortie du mélangeur comporte des basses fréquences proches de la valeur zéro, c'est-à-dire proches du courant continu. Il en résulte alors que le mélangeur présente son propre décalage de tension de sortie (offset) qui constitue un signal d'interférence pour le signal utile. En outre, des moyens d'amplification ayant un gain global de quelques dizaines de dB sont généralement interposés entre le mélangeur et l'étage de conversion analogique numérique. Il en résulte que le décalage en tension (offset) du mélangeur peut saturer l'étage de conversion analogique numérique. Ce problème est d'ailleurs mentioné dans le document US-A-5 613 223.

Par ailleurs, la partie radiofréquence d'un mélangeur doit présenter un gain élevé, une bonne linéarité, ainsi qu'un faible courant de repos. Afin d'atteindre ces performances, on utilise généralement des moyens de polarisation de cet étage radiofréquence conduisant à faire varier le courant de repos avec le signal d'entrée et à rendre le circuit plus linéaire pour un courant de repos donné. En outre, afin de garantir la stabilité des performances en température, les moyens de polarisation de l'étage radiofréquence du mélangeur utilisent généralement des courants proportionnels à la température absolue (PTAT). Ainsi, les courants de repos de l'étage radiofréquence du mélangeur varient avec la puissance du signal d'entrée et avec la température.

Or, ces variations des courants de repos de l'étage radiofréquence sont notamment une cause de variation de la tension de décalage en sortie du mélangeur et peuvent par conséquent s'avérer gênantes pour maintenir les spécifications sur cette tension de décalage en sortie du mélangeur.

L'invention vise à apporter une solution à ce problème.

Un but de l'invention est d'éviter toute variation de la tension de décalage de sortie du mélangeur, notamment lorsque les courants de repos de l'étage radiofréquence varient avec le signal d'entrée et avec la température.

L'invention propose donc un procédé de contrôle des courants statiques (ou de repos) d'un dispositif de transposition de fréquence du type à conversion directe, ce dispositif comportant un bloc transconducteur recevant le signal d'entrée et un bloc de commutation de courant connecté à la sortie du dispositif.

Selon une caractéristique générale de l'invention, on asservit au moins le mode commun des courants statiques de sortie du dispositif de transposition de fréquence sur un courant proportionnel à un courant de référence et indépendant des courants statiques de sortie du bloc transconducteur.

En d'autres termes, selon l'invention, on contrôle de façon indépendante les courants de repos de l'étage de commutation de courant et ceux de l'étage radiofréquence.

Selon une variante de l'invention, on peut n'asservir que le mode commun des courants statiques de sortie. Cet asservissement peut s'effectuer directement ou indirectement.

Dans le cas d'un asservissement indirect, on asservit en fait le mode commun des courants d'entrée du bloc de commutation de courant sur un courant proportionnel au courant de référence et indépendant des courants statiques de sortie du bloc transconducteur.

Par ailleurs, dans une telle variante, on peut également asservir à zéro la différence des courants d'entrée du bloc de commutation de courants en effectuant un contrôle différentiel des courants statiques de sortie du bloc transconducteur.

Dans une autre variante de l'invention, on peut asservir directement le mode commun des courants statiques de sortie du dispositif de transposition de fréquence sur ledit courant proportionnel au courant de référence et indépendant des courants statiques de sortie du bloc transconducteur.

Là encore, dans cette variante, on peut asservir à zéro la différence des courants statiques de sortie du dispositif de transposition de fréquence en effectuant un contrôle différentiel des courants statiques de sortie du bloc transconducteur.

Selon encore une autre variante de l'invention on peut non seulement asservir le mode commun des courants statiques de sortie sur le courant proportionnel au courant de référence, mais également chacun des courants statiques de sortie sur un courant proportionnel au courant de référence et indépendant des courants statiques de sortie du bloc transconducteur. Là encore, cet asservissement peut s'effectuer de façon indirecte, c'est-à-dire en asservissant chacun des courants d'entrée du bloc de commutation de courant sur un courant proportionnel au courant de référence et indépendant des courants statiques de sortie du bloc transconducteur.

L'invention a également pour objet un dispositif de transposition de fréquence du type à conversion directe, comprenant un bloc transconducteur recevant le signal d'entrée et un bloc de commutation de courant connecté à la sortie du dispositif.

Selon une caractéristique générale de l'invention le dispositif comprend des moyens d'asservissement aptes à asservir au moins le mode commun des courants statiques de sortie du dispositif de transposition de fréquence sur un courant proportionnel à un courant de référence et indépendant des courants statiques de sortie du bloc transconducteur.

Selon un mode de réalisation de l'invention, les moyens d'asservissement sont aptes à asservir le mode commun des courants d'entrée du bloc de commutation de courant sur un courant proportionnel au courant de référence et indépendant des courants statiques de sortie du bloc transconducteur.

Dans ce mode de réalisation, les moyens d'asservissement peuvent comporter une source de courant générant ledit courant de référence sur sa borne de sortie connectée aux deux entrées du bloc de commutation de courant, et un seul amplificateur de courant possédant une première entrée connectée à la borne de sortie de la source de courant, une deuxième entrée connectée aux deux entrées du bloc de commutation de courant et aux deux sorties du bloc transconducteur, et une sortie connectée aux deux sorties du bloc transconducteur.

Le dispositif peut également comprendre en outre, un amplificateur de courant différentiel connecté entre les deux sorties du bloc transconducteur et des moyens de polarisation de ce bloc transconducteur, de façon à asservir à zéro la différence des courants d'entrée du bloc de commutation de courant en effectuant un contrôle différentiel des courants statiques de sortie du bloc transconducteur.

Selon un autre mode de réalisation de l'invention, les moyens d'asservissement sont aptes à asservir directement le mode commun des courants statiques de sortie du dispositif de transposition de fréquence sur ledit courant proportionnel au courant de référence et indépendant des courants statiques de sortie du bloc transconducteur.

Dans un tel mode de réalisation, les moyens d'asservissement peuvent comporter une source de courant générant ledit courant de référence sur sa borne de sortie connectée aux deux entrées du bloc de commutation de courant, et un seul amplificateur de courant possédant une première entrée connectée à la borne de sortie de la source de courant, une deuxième entrée connectée aux deux sorties du bloc de commutation de courant et une sortie connectée aux deux sorties du bloc transconducteur.

Le dispositif peut également comprendre en outre un amplificateur de courant différentiel connecté entre les deux sorties du bloc transconducteur et des moyens de polarisation de ce bloc transconducteur, de façon à asservir à zéro la différence des courants statiques de sortie du dispositif de transposition de fréquence en effectuant un contrôle différentiel des courants statiques de sortie du bloc transconducteur.

Selon encore un autre mode de réalisation de l'invention, les moyens d'asservissement sont également aptes à asservir chacun des courants d'entrée du bloc de commutation de courant sur un courant proportionnel au courant de référence et indépendant des courants statiques de sortie du bloc transconducteur.

Dans un tel mode de réalisation, les moyens d'asservissement peuvent comporter

- une source de courant générant ledit courant de référence sur sa borne de sortie connectée aux deux entrées du bloc de commutation de courant,
- un premier amplificateur de courant possédant une première entrée connectée à la borne de sortie de la source de courant, une sortie connectée à une première entrée du bloc de commutation de courant et à une première sortie du bloc transconducteur, et rebouclée sur une deuxième entrée du premier amplificateur, et
- un deuxième amplificateur de courant possédant une première entrée connectée à la borne de sortie de la source de courant, une sortie connectée à une deuxième entrée du bloc de commutation de courant et à une deuxième sortie du bloc transconducteur, et rebouclée sur une deuxième entrée du deuxième amplificateur.

Le dispositif selon l'invention est avantageusement réalisé sous la forme d'un circuit intégré.

L'invention vise également un terminal d'un système de communication sans fil, par exemple un téléphone mobile cellulaire, incorporant un dispositif de transposition de fréquence tel que défini ci-avant.

D'autres avantages et caractéristiques de l'invention apparaîtront à l'examen de la description détaillée de modes de réalisation et de mise en oeuvre nullement limitative, et des dessins annexés sur lesquels :

- la figure 1 illustre schématiquement un premier mode de réalisation d'un dispositif selon l'invention permettant une première mise en oeuvre du procédé selon l'invention,
- la figure 2 illustre plus particulièrement une réalisation des moyens de polarisation de l'étage radiofréquence d'un dispositif de transposition selon l'invention,
- la figure 3 illustre schématiquement un deuxième mode de réalisation de l'invention permettant une deuxième mise en oeuvre du procédé selon l'invention, et

- la figure 4 illustre schématiquement un troisième mode de réalisation d'un dispositif selon l'invention permettant un troisième mode de mise en oeuvre du procédé selon l'invention.

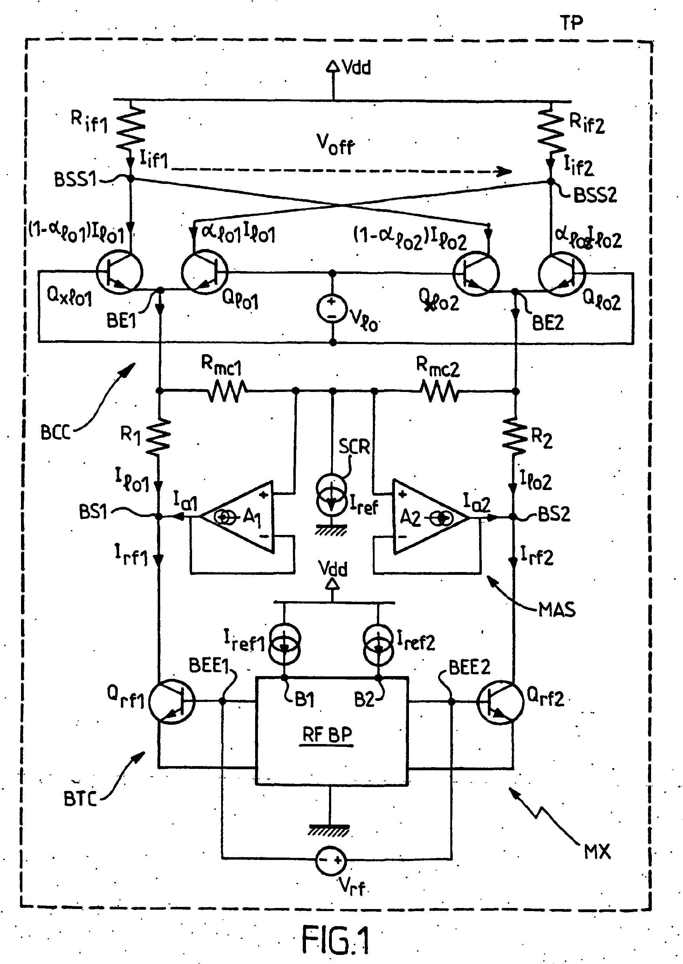

Sur la figure 1, la référence MX désigne un dispositif de transposition de fréquence, ou mélangeur, du type à conversion directe.

Ce mélangeur MX est par exemple incorporé dans l'étage analogique de la chaîne de réception radiofréquence d'un téléphone mobile cellulaire TP.

Ce mélangeur MX possède une borne d'entrée (ici deux bornes BEE1 et BEE2 puisqu'il s'agit d'une structure différentielle), pour recevoir un signal d'entrée (tension) $V_{rf}$ et une borne de sortie (ici deux bornes BSS1 et BSS2) pour délivrer le signal de sortie après transposition.

En outre, le signal d'oscillateur local est ici matérialisé par une tension $V_{lo}$.

La structure utilisée ici pour ce mélangeur est une structure de type GILBERT différentielle.

Plus précisément, une telle structure comporte un bloc transconducteur différentiel BTC pour convertir le signal d'entrée présent sur les bornes BEE1 et BEE2 en un courant différentiel.

Ce bloc BTC comporte dans le cas présent un étage constitué d'une paire différentielle de transistors $Q_{rf1}$ et $Q_{rf2}$ dont les bases sont reliées aux deux bornes d'entrée BEE1 et BEE2.

Les transistors $Q_{rf1}$ et $Q_{rf2}$ sont polarisés par des moyens de polarisation RFBP de structure classique et connue en soi, et recevant notamment sur deux bornes B1 et B2 deux courants $I_{ref1}$ et $I_{ref2}$.

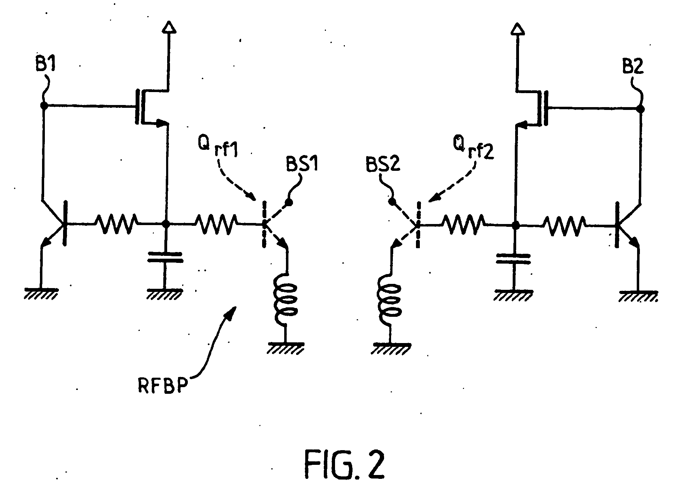

Un mode classique de réalisation de ces moyens de polarisation RFBP est illustré schématiquement sur la figure 2 et l'on n'y reviendra pas ici plus en détail.

A la sortie du bloc transconducteur BTC, c'est-à-dire aux collecteurs des transistors $Q_{rf1}$ et $Q_{rf2}$, est connecté un bloc de commutation de courant BCC aiguillant le courant alternativement vers l'une ou l'autre des deux bornes de sortie BSS1 et BSS2 à la fréquence du signal d'oscillateur local $V_{lo}$.

Ce bloc BCC comporte classiquement deux paires de transistors $Q_{xlo1}$, $Q_{lo1}$, et $Q_{xlo2}$, $Q_{lo2}$.

Chaque résistance $R_{if1}$ et $R_{if2}$, connectée entre les bornes de sortie BSS1, BSS2 et l'alimentation Vdd, représente la charge de sortie du mélangeur MX

Le transconducteur PTC formé notamment des transistors $Q_{rf1}$ et $Q_{rf2}$, utilisé ici pour définir la transconductance du bloc BTC, convertit la puissance ou la tension appliquée à l'entrée BEE1, BEE2 en un courant différentiel qui est une image supposée linéaire du signal d'entrée. Ce signal linéaire est ensuite découpé par une fonction carrée non-linéaire (+1, -1, +1, -1...) réalisée par le double commutateur BCC, à la fréquence du signal d'oscillateur local, ce commutateur faisant office d'aiguilleur dynamique courant. Le signal de sortie est recueilli aux bornes de la charge différentielle $R_{if1}+R_{if2}$.

Le mélangeur MX comporte par ailleurs une source de courant SCR délivrant un courant de référence $I_{ref}$. La borne de sortie de cette source de courant SCR est reliée d'une part à une première borne d'entrée BE1 du bloc de commutation de courant BCC par l'intermédiaire d'une résistance $R_{mc1}$, et à une deuxième borne d'entrée BE2 du bloc de commutation de courant BCC par l'intermédiaire d'une autre résistance $R_{mc2}$.

Deux amplificateurs de courant A1 et A2 sont connectés entre la borne de sortie de la source de courant et les bornes de sortie respectives (collecteurs des transistors $Q_{rf1}$ et $Q_{rf2}$) BS1 et BS2 du bloc transconducteur BTC.

Plus précisément, l'entrée + de l'amplificateur A1 est reliée à la borne de sortie de la source de courant SCR. La sortie de cet amplificateur A1 est connectée à la borne BS1 et également à la borne BE1 par l'intermédiaire d'une résistance R1. Par ailleurs, la sortie de l'amplificateur A1 est rebouclée sur son entrée -.

D'une façon analogue, l'entrée + de l'amplificateur A2 est connectée à la borne de sortie de la source de courant SCR. La sortie de cet amplificateur A2 est reliée à la borne BS2 ainsi qu'à la borne BE2 par l'intermédiaire d'une résistance R2. La sortie de l'amplificateur A2 est rebouclée sur son entrée -.

Il ressort de cette architecture que les courants d'entrée $I_{lo1}$ et $I_{lo2}$ du bloc de commutation de courant BCC sont donnés respectivement par les formules (I) et (II) ci-dessous, dans le cas particulier et pratique où $R_{mc1} = R_{mc2} = R_{mc}$ et où les potentiels des noeuds BE1 ET BE2 sont identiques (transistors du bloc BCC identiques).

$$I_{lo1} = \frac{R_{mc} \cdot I_{ref}}{2 \cdot R_1} \qquad (I)$$

$$I_{lo2} = \frac{R_{mc} \cdot I_{ref}}{2 \cdot R_2} \qquad \text{(II)}$$

On remarque donc que ces courants d'entrée $I_{lo1}$ et $I_{lo2}$ sont asservis sur un courant proportionnel au courant $I_{ref}$ délivré par la source de courant SCR, et indépendant des courants statiques de sortie $I_{rf1}$ et $I_{rf2}$ du bloc transconducteur BTC.

La source de courant SCR et les deux amplificateurs de courant A1 et A2 forment ainsi des moyens d'asservissement MAS destinés à asservir les courants précités sur le courant proportionnel au couvrant $I_{ref}$.

En particulier, même si les courants $I_{rf1}$ et $I_{rf2}$ sont des courants proportionnels à la température absolue (PTAT) ou augmentant avec la puissance du signal radiofréquence d'entrée, les courants $I_{lo1}$ et $I_{lo2}$, et par voie de conséquence les courants de sortie $I_{if1}$ et $I_{if2}$ du mélangeur MX, demeurent constants pour autant que le courant $I_{ref}$ demeure constant.

En conséquence, la tension de décalage de sortie du mélangeur, référencée $V_{off}$, qui est fournie par la formule (III) ci-dessous

$$V_{off} = \frac{1}{2} \cdot (R_{if1} + R_{if2}) \cdot \left( \frac{R_{mc}}{2 \cdot R_1} + \frac{R_{mc}}{2 \cdot R_2} \right) \cdot I_{ref} \cdot \left( \frac{R_{if1} - R_{if2}}{R_{if1} + R_{if2}} + (1 - (\alpha_{lo1} + \alpha_{lo2})) - (\alpha_{lo1} - \alpha_{lo2}) \cdot \frac{R_{mc} \cdot R_1 - R_{mc} \cdot R_2}{R_{mc} \cdot R_1 + R_{mc} \cdot R_2} \right)$$

$$\text{(III)}$$

demeure constante, même si la température et la puissance du signal d'entrée varient.

On va maintenant illustrer sur un exemple numérique les avantages de l'invention.

On suppose à cet égard que les courants de repos $I_{rf1}$ et $I_{rf2}$ sont proportionnels à la température absolue (PTAT) et augmentent avec la puissance du signal d'entrée.

On suppose également que la plage de température de fonctionnement est définie de -40°C à 100°C. La variation d'un courant PTAT par rapport à la valeur nominale de 300°K s'étend entre - 22% et + 24% sur toute la plage de température.

On suppose également que les courants $I_{rf1}$ et $I_{rf2}$ augmentent de 20% pour un niveau d'entrée de -23 DBm, ce qui correspond à un niveau d'entrée d'un signal dit « blocker ».

On suppose enfin que les résistances $R_{if1}$, et $R_{if2}$, sont égales à la valeur de 650 Ohms avec une erreur relative de 1%.

Le décalage statique $V_{off}$ est alors égal à 7,8 mV avec des courants $I_{if1}$ et $I_{if2}$ égaux à 1,2 mA.

Avec un mélangeur de l'art antérieur, les courants de sortie $I_{if1}$, et $I_{if2}$ varient de 0,936 mA à 1,488 mA dans la plage de température, ce qui conduit à une variation du décalage de tension statique $V_{off}$ de 3,6 mV, alors que les spécifications requièrent une variation inférieure à 1 mV.

Parallèlement, lorsqu'un « blocker » est présent à l'entrée du mélangeur, les courants de sortie augmentent de 240 microampères, ce qui conduit à une augmentation du décalage $V_{off}$ de 1,56 mV alors que les spécifications requièrent généralement une variation inférieure à 100 microvolts.

Par contre, pour un mélangeur selon l'invention, la variation en température des courants de sortie est fixée par le courant de référence $I_{ref}$ qui peut être théoriquement constant en température ce qui signifie qu'il varie de moins de 5% dans la gamme de températures. En conséquence, la variation de $V_{off}$ en température est de 400 microvolts.

En ce qui concerne la variation des courants de sortie avec la puissance du signal d'entrée, celle-ci dépend du gain statique en boucle ouverte des moyens d'asservissement (MAS). Si l'on suppose que l'on a plus que 40 dB, cela signifie que les courants de sortie varient de moins de 0,2% lorsque les courants $I_{rf1}$ et $I_{rf2}$ augmentent de 20%. En conséquence, $V_{off}$ varie de 16 microvolts.

Dans la variante qui vient d'être exposée, on asservissait non seulement le mode commun des courants d'entrée du bloc de commutation de courant, et par conséquent des courants de sortie du mélangeur, mais également chacun de ces courants individuellement.

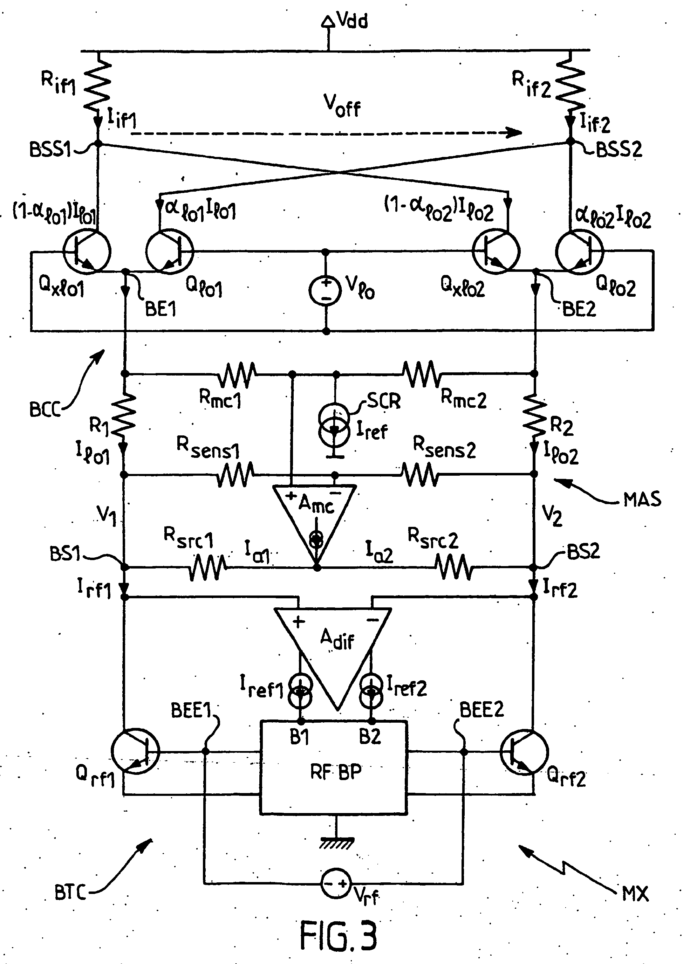

Dans une variante illustrée sur la figure 3, les moyens d'asservissement MAS ne comportent ici qu'un seul amplificateur de courant $A_{mc}$ qui va permettre d'asservir le mode commun $I_{lo1} + I_{lo2}$ des courants d'entrée du bloc de commutation de courant sur un courant proportionnel au courant de référence $I_{ref}$ et indépendant des courants statiques de sortie du bloc transconducteur BTC.

Plus précisément, cet amplificateur unique $A_{mc}$ possède une entrée + reliée à la borne BE1 par l'intermédiaire de la résistance $R_{mc1}$ ainsi qu'à la borne de sortie de la source de référence SCR. Cette entrée + est également reliée à la borne d'entrée BE2 par l'intermédiaire de la résistance $R_{mc2}$.

L'entrée - de l'amplificateur $A_{mc}$ est reliée d'une part à la borne de sortie BS1 du bloc transconducteur BTC par l'intermédiaire d'une résistance $R_{sens1}$, et à la borne BS2 par l'intermédiaire d'une résistance $R_{sens2}$.

Par ailleurs, la sortie de cet amplificateur $A_{mc}$ est reliée aux deux bornes BS1 et BS2 par l'intermédiaire de deux résistances $R_{src1}$ et $R_{src2}$.

Par ailleurs, un amplificateur de courant différentiel $A_{dif}$ est connecté entre les deux bornes de sortie BS1 et BS2 et les deux bornes B1 et B2 des moyens de polarisation RFFPP. Cet amplificateur de courant différentiel $A_{dif}$ va donc asservir à zéro la différence $I_{lo1} - I_{lo2}$ des courants d'entrée du bloc de commutation de courant en contrôlant la différence des courants de référence $I_{ref1}$ et $I_{ref2}$ de l'étage radiofréquence de façon à rendre nulle la différence de tension $V_1 - V_2$.

Ainsi, en faisant l'hypothèse que les résistances $R_1$ et $R_2$ sont égales de même que les résistances $R_{mc1}$ et $R_{mc2}$, le courant de mode commun des courants d'entrée du bloc de commutation de courant est fourni par la formule (IV) ci-dessous

$$I_{lo1} + I_{lo2} = R_{mc} \, I_{ref}/R \qquad\qquad \textbf{(IV)}$$

avec $R = R_1 = R_2$

il en résulte donc que $V_{off}$ est donné par la formule (V) ci-dessous.

$$V_{off} = \frac{1}{2} \cdot (R_{if1} + R_{if2}) \cdot R_{mc} \cdot I_{ref} \cdot \left( \frac{R_{if1} - R_{if2}}{R_{if1} + R_{if2}} + \left(1 - (\alpha_{lo1} + \alpha_{lo2})\right) \right) / R$$

$$\textbf{(V)}$$

On remarque donc que $V_{off}$ ne dépend pas des courants de repos de l'étage radiofréquence.

Cette variante présente un avantage supplémentaire en ce sens que, par l'utilisation de l'amplificateur $A_{dif}$, le bloc BTC est symétrique puisque $I_{rf1}$ est égal à $I_{rf2}$, ce qui réduit la non-linéarité du second ordre de ce bloc transconducteur, ce qui est également bénéfique pour les variations de $V_{off}$

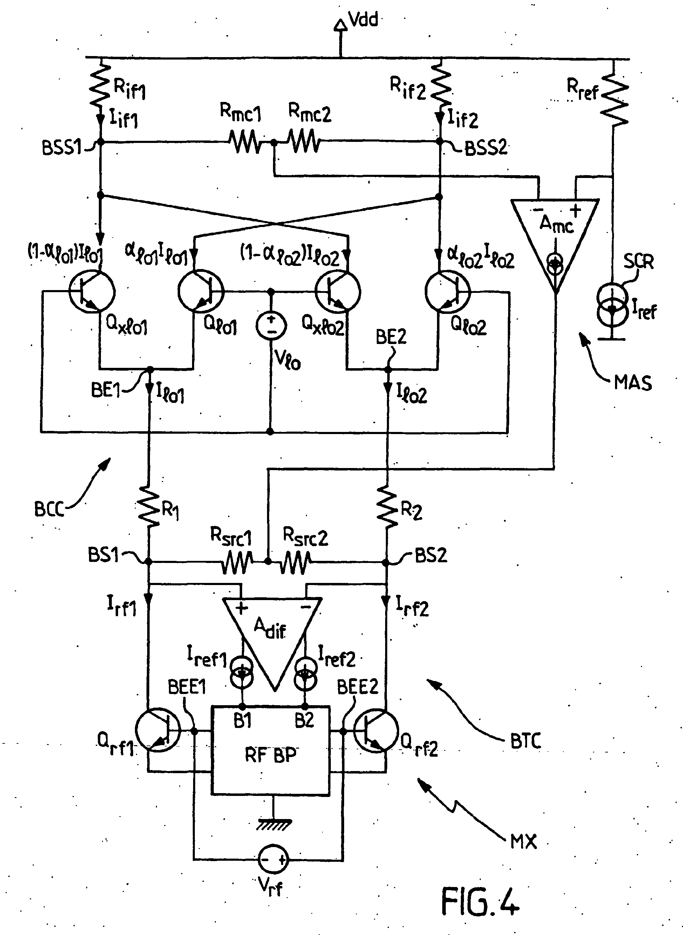

Alors que dans les deux variantes qui viennent d'être décrites, les moyens d'asservissement MAS agissaient sur les courants d'entrée $I_{lo1}$, et $I_{lo2}$ du bloc de commutation de courant BCC pour asservir les courants de sortie $I_{if1}$ et $I_{if2}$ du mélangeur, ou à tout le moins leur mode commun, les moyens d'asservissement MAS de la variante illustrée sur la figure 4 asservissent directement le mode commun $I_{if1} + I_{if2}$ des courants de sortie du mélangeur MX sur un courant proportionnel au courant de référence $I_{ref}$.

A cet égard, les moyens d'asservissement MAS comportent, outre la source de courant SCR, un seul amplificateur de courant $A_{mc}$ possédant une première entrée + connectée à la borne de sortie de la source de courant, et une deuxième entrée - connectée aux deux sorties BSS1 et BSS2 du bloc de commutation de courant par l'intermédiaire des deux résistances $R_{mc1}$ et $R_{mc2}$.

Par ailleurs, la sortie de cet amplificateur de courant $A_{mc}$ est reliée aux deux sorties BS1 et BS2 du bloc transconducteur BTC par l'intermédiaire de deux résistances $R_{src1}$ et $R_{src2}$.

Comme dans la variante illustrée sur la figure 3, le contrôle différentiel est effectué par l'amplificateur différentiel $A_{dif}$.

L'avantage de cette variante réside dans le fait qu'elle minimise la connectique sur la partie radiofréquence.


## Revendications

1. Procédé de contrôle des courants statiques d'un dispositif de transposition de fréquence du type à conversion directe, comportant un bloc transconducteur recevant le signal d'entrée et un bloc de commutation de courant connecté à la sortie du dispositif, **caractérisé par le fait qu'**on asservit au moins le mode commun des courants statiques ($I_{if1}$, $I_{if2}$) de sortie du dispositif de transposition de fréquence sur un courant proportionnel à un courant de référence ($I_{ref}$) et indépendant des courants statiques de sortie du bloc transconducteur.

2. Procédé selon là revendication 1, **caractérisé par le fait qu'**on asservit le mode commun des courants statiques de sortie en asservissant le mode commun (I) des courants d'entrée ($I_{lo1}$, $I_{lo2}$) du bloc de commutation de courant sur un courant proportionnel au courant de référence ($I_{ref}$) et indépendant des courants statiques de sortie du bloc transconducteur.

3. Procédé selon la revendication 2, **caractérisé par le fait qu'**on asservit à zéro la différence des courants d'entrée du bloc de commutation de courant en effectuant un contrôle différentiel ($A_{dif}$) des courants statiques de sortie du bloc transconducteur.

4. Procédé selon la revendication 1, **caractérisé par le fait qu'**on asservit directement le mode commun des courants statiques de sortie du dispositif de transposition de fréquence sur ledit courant proportionnel au courant de référence ($I_{ref}$) et indépendant des courants statiques de sortie du bloc transconducteur.

5. Procédé selon la revendication 4, **caractérisé par le fait qu'**on asservit à zéro la différence des courants statiques de sortie du dispositif de transposition de fréquence en effectuant un contrôle différentiel ($A_{dif}$) des courants statiques de sortie du bloc transconducteur.

6. Procédé selon la revendication 2, **caractérisé par le fait qu'**on asservit également chacun des courants statiques de sortie à sur un courant proportionnel au courant de référence et indépendant des courants statiques de sortie du bloc transconducteur en asservissant chacun des courants d'entrée du bloc de commutation de courant sur un courant proportionnel au courant de référence et indépendant des courants statiques de sortie du bloc transconducteur.

7. Dispositif de transposition de fréquence du type à conversion directe, comprenant un bloc transconducteur (BTC) recevant le signal d'entrée et un bloc de commutation de courant (BCC) connecté à la sortie du dispositif, **caractérisé par le fait qu'**il comprend des moyens d'asservissement (MAS) aptes à asservir au moins le mode commun des courants statiques de sortie du dispositif de transposition de fréquence sur un courant proportionnel à un courant de référence ($I_{ref}$) et indépendant des courants statiques de sortie du bloc transconducteur.

8. Dispositif selon la revendication 7, **caractérisé par le fait que** les moyens d'asservissement (MAS) sont aptes à asservir le mode commun des courants d'entrée ($I_{Io1}$, $I_{Io2}$) du bloc de commutation de courant sur un courant proportionnel au courant de référence et indépendant des courants statiques de sortie du bloc transconducteur.

9. Dispositif selon la revendication 8, **caractérisé par le fait que** les moyens d'asservissement (MAS) comportent

   - une source de courant (SCR) générant ledit courant de référence sur sa borne de sortie connectée aux deux entrées du bloc de commutation de courant, et
   - un seul amplificateur ($A_{mc}$) de courant possédant une première entrée connectée à la borne de sortie de la source de courant, une deuxième entrée connectée aux deux entrées du bloc de commutation de courant et aux deux sorties du bloc transconducteur, et une sortie connectée aux deux sorties du bloc transconducteur.

10. Dispositif selon la revendication 9, **caractérisé par le fait qu'**il comprend en outre un amplificateur de courant différentiel ($A_{dif}$) connecté entre les deux sorties du bloc transconducteur et des moyens de polarisation de ce bloc transconducteur, de façon à asservir à zéro la différence des courants d'entrée du bloc de commutation de courant en effectuant un contrôle différentiel des courants statiques de sortie du bloc transconducteur.

11. Dispositif selon la revendication 7, **caractérisé par le fait que** les moyens d'asservissement (MAS) sont aptes à asservir directement le mode commun des courants statiques de sortie du dispositif de transposition de fréquence sur ledit courant proportionnel au courant de référence et indépendant des courants statiques de sortie du bloc transconducteur.

12. Dispositif selon la revendication 11, **caractérisé par le fait que** les moyens d'asservissement (MAS) comportent

   - une source de courant (SCR) générant ledit courant de référence sur sa borne de sortie connectée aux deux entrées du bloc de commutation de courant, et
   - un seul amplificateur de courant ($A_{mc}$) possédant une première entrée connectée à la borne de sortie de la source de courant, une deuxième entrée connectée aux deux sorties du bloc de commutation de courant et une sortie connectée aux deux sorties du bloc transconducteur.

13. Dispositif selon la revendication 12, **caractérisé par le fait qu'**il comprend en outre un amplificateur de courant différentiel ($A_{dif}$) connecté entre les deux sorties du bloc transconducteur et des moyens de polarisation de ce bloc transconducteur, de façon à asservir à zéro la différence des courants statiques de sortie du dispositif de transposition de fréquence en effectuant un contrôle différentiel des courants statiques de sortie du bloc transconducteur.

14. Dispositif selon la revendication 8, **caractérisé par le fait que** les moyens d'asservissement (MAS) sont également aptes à asservir chacun des courants d'entrée du bloc de commutation de courant sur un courant proportionnel au courant de référence et indépendant des courants statiques de sortie du bloc transconducteur.

15. Dispositif selon la revendication 14, **caractérisé par le fait que** les moyens d'asservissement (MAS) comportent

   - une source de courant (SCR) générant ledit courant de référence sur sa borne de sortie connectée aux deux entrées du bloc de commutation de courant,
   - un premier amplificateur (A1) de courant possédant une première entrée connectée à la borne de sortie de la source de courant, une sortie connectée à une première entrée du bloc de commutation de courant et à une première sortie du bloc transconducteur, et rebouclée sur une deuxième entrée du premier amplificateur, et
   - un deuxième amplificateur de courant (A2) possédant une première entrée connectée à la borne de sortie de la source de courant, une sortie connectée à une deuxième entrée du bloc de commutation de courant et à une deuxième sortie du bloc transconducteur, et rebouclée sur une deuxième entrée du deuxième amplificateur.

16. Dispositif selon l'une des revendications 7 à 15, **caractérisé par le fait qu'**il est réalisé sous forme d'un circuit intégré.

17. Terminal d'un système de communication sans fil, **caractérisé par le fait qu'**il incorpore un dispositif selon l'une des revendications 7 à 16.

18. Terminal selon la revendication 17, **caractérisé par le fait qu'**il forme un téléphone mobile cellulaire.

**Claims**

1. Process for checking the static currents of a direct conversion type of frequency transposition device, comprising a transconductor block receiving the input signal and a current switching block connected to the output from the device, **characterised by** the fact that at least the common mode of the static output currents ($I_{if1}$, $I_{if2}$) from the frequency transposition device are servocontrolled to a current proportional to a reference current ($I_{ref}$) and independent of the static output currents from the transconductor block.

2. Process according to claim 1, **characterised by** the fact that the common mode of static output currents is servocontrolled by servocontrolling the common mode of input currents ($I_{lo1}$, $I_{lo2}$) to the current switching block to a current proportional to the reference current ($I_{ref}$) independent of static output currents from the transconductor block.

3. Process according to claim 2, **characterised by** the fact that the difference between the input currents to the current switching block are servocontrolled to zero by making a differential check ($A_{dif}$) of the static output currents from the transconductor block.

4. Process according to claim 1, **characterised by** the fact that the common mode of static output currents from the frequency transposition device is servocontrolled directly to the said current proportional to the reference current ($I_{ref}$) independent of static output currents from the transconductor block.

5. Process according to claim 4, **characterised by** the fact that the difference between the static output currents from the frequency transposition device are servocontrolled to zero by making a differential check ($A_{dif}$) of the static output currents from the transconductor block.

6. Process according to claim 2, **characterised by** the fact that each of the static output currents is also servocontrolled to a current proportional to the reference current and independent of the static output currents from the transconductor block, by servocontrolling each of the input currents to the current switching block onto a current proportional to the reference current independent of the status output currents from the transconductor block.

7. Direct conversion type of frequency transposition device, comprising a transconductor block (BTC) receiving the input signal and a current switching block (BCC) connected to the output from the device, **characterised by** the fact that it comprises servocontrol means (MAS) capable of servocontrolling at least the common mode of the static output currents from the frequency transposition device to a current proportional to a reference current ($I_{ref}$) and independent of the static output currents from the transconductor block.

8. Device according to claim 7, **characterised by** the fact that the servocontrol means (MAS) are capable of servocontrolling the common mode of input currents ($I_{lo1}$, $I_{lo2}$) to the current switching block to a current proportional to the reference current and independent of the static output currents from the transconductor block.

9. Device according to claim 8, **characterised by** the fact the the servocontrol means (MAS) comprise

   - a current source (SCR) generating the said reference current on its output terminal connected to the two inputs to the current switching block, and
   - a single current amplifier ($A_{mc}$) that has a first input connected to the output terminal from the current source, a second input connected to the two inputs to the current switching block and to the two outputs from the transconductor block, and an output connected to the two outputs from the transconductor block.

10. Device according to claim 9, **characterised by** the fact that it also comprises a differential current amplifier ($A_{dif}$) connected between the two outputs from the transconductor block and means of polarising this transconductor block, so as to servocontrol the difference between input currents to the current switching block to zero by making a differential control of static output currents from the transconductor block.

11. Device according to claim 7, **characterised by** the fact that the servocontrol means (MAS) are capable of directly servocontrolling the common mode of static output currents from the frequency transposition device to the said current proportional to the reference current and independent of the static output currents from the transconductor block.

12. Device according to claim 11, **characterised by** the fact that the servocontrol means (MAS) comprise

   - a current source (SCR) generating the said reference current on its output terminal connected to the two inputs to the current switching block, and
   - a single current amplifier ($A_{mc}$) that has a first input connected to the output terminal from the current source, a second input connected to the two outputs from the current switching block and an output connected to the two outputs from the transconductor block.

13. Device according to claim 12, **characterised by** the fact that it also comprises a differential current amplifier ($A_{dif}$) connected between the two outputs from the transconductor block and means of polarising this transconductor block, so as to servocontrol the difference between the static output currents from the frequency transposition device to zero by making a differential control of static output currents from the transconductor block.

14. Device according to claim 8, **characterised by** the fact that the servocontrol means (MAS) can also servocontrol each input current to the current switching block to a current proportional to the reference current and independent of the static output currents from the transconductor block.

15. Device according to claim 14, **characterised by** the fact that the servocontrol means (MAS) comprise

   - a current source (SCR) generating the said reference current on its output terminal connected to the two inputs to the current switching block, and
   - a first current amplifier (A1) that has a first input connected to the output terminal from the current source, an output connected to a first input to the current switching block and to a first output from the transconductor block, and looped back to a second input to the first amplifier, and
   - a second current amplifier (A2) with a first input connected to the output terminal of the current source, an output connected to a second input of the current switching block and to a second output from the transconductor block and looped back to a second input of the second amplifier.

16. Device according to one of claims 7 to 15, **characterised by** the fact that it is made in the form of an integrated circuit.

17. A terminal of a wireless communication system, **characterised by** the fact that it incorporates a device according to one of claims 7 to 16.

**18.** A terminal according to claim 17, **characterised by** the fact that it is a mobile cell phone.


**Patentansprüche**

**1.** Verfahren zur Steuerung der statischen Ströme einer Frequenztranspositionsvorrichtung des Typs mit direkter Umsetzung, die einen das Eingangssignal empfangenden Transkonduktanzblock und einen mit dem Ausgang der Vorrichtung verbundenen Stromwenderblock aufweist, **dadurch gekennzeichnet, daß** zumindest der Gleichtakt der statischen Ausgangsströme ($I_{if1}$, $I_{if2}$) der Frequenztranspositionsvorrichtung an einem zu einem Referenzstrom ($I_{ref}$) proportionalen und von den statischen Ausgangsströmen des Transkonduktanzblocks unabhängigen Strom geregelt wird.

**2.** Verfahren nach Anspruch 1, **dadurch gekennzeichnet, daß** der Gleichtakt der statischen Ausgangsströme geregelt wird, indem der Gleichtakt der Eingangsströme ($I_{lo1}$, $I_{lo2}$) des Stromwenderblocks an einem zu dem Referenzstrom ($I_{ref}$) proportionalen und von den statischen Ausgangsströmen des Transkonduktanzblocks unabhängigen Strom geregelt wird.

**3.** Verfahren nach Anspruch 2, **dadurch gekennzeichnet, daß** die Differenz der Eingangsströme des Stromwenderblocks auf Null geregelt wird, indem eine Differentialsteuerung ($A_{dif}$) der statischen Ausgangsströme des Transkonduktanzblocks durchgeführt wird.

**4.** Verfahren nach Anspruch 1, **dadurch gekennzeichnet, daß** der Gleichtakt der statischen Ausgangsströme der Frequenztranspositionsvorrichtung an dem zu dem Referenzstrom ($I_{ref}$) proportionalen und von den statischen Ausgangsströmen des Transkonduktanzblocks unabhängigen Strom direkt geregelt wird.

**5.** Verfahren nach Anspruch 4, **dadurch gekennzeichnet, daß** die Differenz der statischen Ausgangsströme der Frequenztranspositionsvorrichtung auf Null geregelt wird, indem eine Differentialsteuerung ($A_{dif}$) der statischen Ausgangsströme des Transkonduktanzblocks durchgeführt wird.

**6.** Verfahren nach Anspruch 2, **dadurch gekennzeichnet, daß** außerdem jeder der statischen Ausgangsströme an einem zu dem Referenzstrom proportionalen und von den statischen Ausgangsströmen des Transkonduktanzblocks unabhängigen Strom geregelt wird, indem jeder der Eingangsströme des Stromwenderblocks an einem zu dem Referenzstrom proportionalen und von den statischen Ausgangsströmen des Transkonduktanzblocks unabhängigen Strom geregelt wird.

**7.** Frequenztranspositionsvorrichtung des Typs mit direkter Umsetzung, die einen das Eingangssignal empfangenden Transkonduktanzblock (BTC) und einen mit dem Ausgang der Vorrichtung verbundenen Stromwenderblock (BCC) aufweist, **dadurch gekennzeichnet, daß** sie Regelungseinrichtungen (MAS) aufweist, die in der Lage sind, zumindest den Gleichtakt der statischen Ausgangsströme der Frequenztranspositionsvorrichtung an einem zu einem Referenzstrom ($I_{ref}$) proportionalen und von den statischen Ausgangsströmen des Transkonduktanzblocks unabhängigen Strom zu regeln.

**8.** Vorrichtung nach Anspruch 7, **dadurch gekennzeichnet, daß** die Regelungseinrichtungen (MAS) in der Lage sind, den Gleichtakt der Eingangsströme ($I_{lo1}$, $I_{lo2}$) des Stromwenderblocks an einem zu dem Referenzstrom proportionalen und von den statischen Ausgangsströmen des Transkonduktanzblocks unabhängigen Strom zu regeln.

**9.** Vorrichtung nach Anspruch 8, **dadurch gekennzeichnet, daß** die Regelungseinrichtungen (MAS) aufweisen:

- eine Stromquelle (SCR), die den Referenzstrom an ihrem Ausgangsanschluß erzeugt, der mit den zwei Eingängen des Stromwenderblocks verbunden ist, und
- einen einzigen Stromverstärker ($A_{mc}$), der einen mit dem Ausgangsanschluß der Stromquelle verbundenen ersten Eingang, einen mit den zwei Eingängen des Stromwenderblocks und den zwei Ausgängen des Transkonduktanzblocks verbundenen zweiten Eingang und einen mit den zwei Ausgängen des Transkonduktanzblocks verbundenen Ausgang hat.

**10.** Vorrichtung nach Anspruch 9, **dadurch gekennzeichnet, daß** sie ferner einen zwischen den zwei Ausgängen des Transkonduktanzblocks und Vorspannungseinrichtungen dieses Transkonduktanzblocks verbundenen Differentialstromverstärker ($A_{dif}$) aufweist, um durch Durchführen einer Differentialsteuerung der statischen Ausgangsströme des Transkonduktanzblocks die Differenz der Eingangsströme des Stromwenderblocks auf Null zu regeln.

**11.** Vorrichtung nach Anspruch 7, **dadurch gekennzeichnet, daß** die Regelungseinrichtungen (MAS) in der Lage sind, den Gleichtakt der statischen Ausgangsströme der Frequenztranspositionsvorrichtung an dem zu dem Referenzstrom proportionalen und von den statischen Ausgangsströmen des Transkonduktanzblocks unabhängigen Strom direkt zu regeln.

**12.** Vorrichtung nach Anspruch 11, **dadurch gekennzeichnet, daß** die Regelungseinrichtungen (MAS) aufweisen:

- eine Stromquelle (SCR), die den Referenzstrom an ihrem Ausgangsanschluß erzeugt, der mit den zwei Eingängen des Stromwenderblocks verbunden ist, und
- einen einzigen Stromverstärker ($A_{mc}$), der einen mit dem Ausgangsanschluß der Stromquelle verbundenen ersten Eingang, einen mit den zwei Ausgängen des Stromwenderblocks verbundenen zweiten Eingang und einen mit den zwei Ausgängen des Transkonduktanzblocks verbundenen Ausgang hat.

**13.** Vorrichtung nach Anspruch 12, **dadurch gekennzeichnet, daß** sie ferner einen zwischen den zwei Ausgängen des Transkonduktanzblocks und Vorspannungseinrichtungen dieses Transkonduktanzblocks verbundenen Differentialstromverstärker ($A_{dif}$) aufweist, um durch Durchführen einer Differentialsteuerung der statischen Ausgangsströme des Transkonduktanzblocks die Differenz der statischen Ausgangsströme der Frequenztranspositionsvorrichtung auf Null zu regeln.

**14.** Vorrichtung nach Anspruch 8, **dadurch gekennzeichnet, daß** die Regelungseinrichtungen (MAS) außerdem in der Lage sind, jeden der Eingangsströme des Stromwenderblocks an einem zu dem Referenzstrom proportionalen und von den statischen Ausgangsströmen des Transkonduktanzblocks unabhängigen Strom zu regeln.

**15.** Vorrichtung nach Anspruch 14, **dadurch gekennzeichnet, daß** die Regelungseinrichtungen (MAS) aufweisen:

- eine Stromquelle (SCR), die den Referenzstrom an ihrem Ausgangsanschluß erzeugt, der mit den zwei Eingängen des Stromwenderblocks verbunden ist,
- einen ersten Stromverstärker (A1), der einen mit dem Ausgangsanschluß der Stromquelle verbundenen ersten Eingang hat, sowie einen Ausgang, der mit einem ersten Eingang des Stromwenderblocks und mit einem ersten Ausgang des Transkonduktanzblocks verbunden ist und zu einem zweiten Eingang des ersten Verstärkers zurück verbunden ist, und
- einen zweiten Stromverstärker (A2), der einen mit dem Ausgangsanschluß der Stromquelle verbundenen ersten Eingang hat, sowie einen Ausgang, der mit einem zweiten Eingang des Stromwenderblocks und mit einem zweiten Ausgang des Transkonduktanzblocks verbunden ist und zu einem zweiten Eingang des zweiten Verstärkers zurück verbunden ist.

**16.** Vorrichtung nach einem der Ansprüche 7 bis 15, **dadurch gekennzeichnet, daß** sie in Form einer integrierten Schaltung ausgeführt ist.

**17.** Endgerät eines drahtlosen Kommunikationssystems, **dadurch gekennzeichnet, daß** es eine Vorrichtung gemäß einem der Ansprüche 7 bis 16 aufweist.

**18.** Endgerät nach Anspruch 17, **dadurch gekennzeichnet, daß** es ein zellulares Mobiltelefon bildet.

FIG.1

FIG. 2

FIG.3

FIG.4

**EP 1 398 873 B1**

**Documents brevets cités dans la description**

• US 5613223 A